# EUROPEAN PATENT SPECIFICATION

(11) **EP 0 508 735 B1**
(45) Date of publication and mention of the grant of the patent: **06.11.1996**
(21) Application number: 92303094.4
(22) Date of filing: 08.04.1992
(51) Int. Cl.: H01P 1/205, H01P 1/213, H01P 1/203

(54) **Microwave filter**
Mikrowellenfilter
Filtre hyperfréquence

(30) Priority: 12.04.1991 FI 911799
(43) Date of publication of application: 14.10.1992
(73) Proprietor: LK-PRODUCTS OY, SF-90440 Kempele (FI)
(72) Inventor: Turunen, Aimo, SF-90120 Oulu (FI)
(74) Representative: Frain, Timothy John

(56) References cited:
- PHILIPS TECHNICAL REVIEW vol. 39, no. 10, October 1980, EINDHOVEN NL pages 257 - 268 P. HARROP ET AL. 'Low-noise 12 GHz front-end designs for direct satellite television reception'
- MICROWAVE JOURNAL vol. 21, no. 9, September 1978, DEDHAM US pages 68 - 73 J.P. ROONEY ET AL. 'Printed circuit integration of MW filters'

## Description

The invention relates to air insulated filters for use in radio apparatus comprising a plurality of resonators in an electrically conductive casing.

Radiotelephone manufacturers typically use individual (radio frequency) RF filters bought from their manufacturer as separate components already tuned to specifications. Filters based on quarter-wave resonators, such as air insulated rod resonators, helix resonators and ceramic resonators, are thus ready made assemblies encapsulated by the manufacturer in a metal case having solder ears for fixing onto a printed board and connectors for the electrical interface.

Microwave Integrated Circuits are described for use in a two stage preamplifier in an article by P. Harrop et al, 'Low noise 12GHz front-end designs for direct satellite television reception', Philips Technical Review vol. 39, no. 10, October 1980 pages 257-268.

From the beginning of the design, a radiotelephone manufacturer takes into account the mounting of filters so that within the radiotelephone housing, which is usually a structure containing compartments and made by casting or possibly by pressing and bending sheet metal, a unique compartment is usually allocated for the high frequency filters, such as the duplex filter. The housing can also be made of plastics or similar material, which at least partially is coated with a conducting material. Besides the filters, there are separate compartments for the high frequency sections of the transmitter and receiver paths, for the logic and for the synthesizers. The printed boards located in the compartments are shielded with metallic RF covers at the upper side and possibly below, while the compartment side walls provide the sideways shielding. This known compartment structure prevents mutual interference between different functional blocks, or the so called electromagnetic interference. In the assembly of a radiotelephone the printed boards with components attached to them are placed in the housing, and the boards are electrically interconnected. Thus also ready made encapsulated filters are attached to the printed boards, the filters and the printed circuit boards requiring connectors for mechanical as well as for electrical connection.

It is also known to manufacture filters made by providing strip line resonators directly on the printed board's surface, whereby the desired resonator pattern is etched on the printed board in connection with its manufacture. Good accuracy and reproducibility are advantages of this method.

The commonly used technique of this type has some disadvantages. The compartment structure may well not use the available space of the radiotelephone in a non-optional way, for example, the encapsulated antenna filters may occupy their own compartment with plenty of space around them. As far as high frequency filters are concerned it is unnecessary to place them in their own compartments, even covered by possible RF covers, because the manufacturer always supplies the filters with a housing. The encapsulated individual filters require a printed board as a mounting base, from which signals are coupled, through an expensive connector and a cable to the front end of a receiver, and correspondingly, a separate connector and cable are required to couple signals from the transmitter output stage to the duplex filter. This mounting must further be somehow fixed to the frame compartment.

A filter using line resonators requires an excellent Q factor, which is not easily obtained on a common printed board substrate.

This invention presents a way in which filters based on quarter-wave resonators can be placed in a radiotelephone, easily and without the above mentioned disadvantages of prior art. The objective is to obtain a resonator structure, where it is possible to utilize the conducting partition walls and covers, which are inherent parts of a radiotelephone, and where no expensive connector elements are required for mechanical and electrical interfaces.

According to the present invention there is provided an air insulated high frequency filter for use in a radio apparatus, comprising a plurality of resonators in an electrically conductive casing, characterised in that the resonators comprise finger-like projections entirely coated with electrically conductive material, and in that the plurality of finger-like projections are integrally formed in a portion of a circuit board adapted for the mounting of electrical components.

The filter according to the invention is very advantageously realized, because no separate printed board, interface or housing is required, but the filter can be manufactured together with the printed boards which anyway are used in the telephone. Although it is possible to use inexpensive material for the printed board it is possible to obtain low filter losses. A small filter size is not necessarily achieved, but on the other hand the filter is very light-weight.

The filter is not made as an individual component, but as a part of the manufacturing process of the printed board, which in any case is needed in the radiotelephone. In an easy and simple way the resonator can be connected to form a functional part of the rest of the circuit, because the input and output conductors can be formed directly on the printed board, obviating the need for separate connectors and cables. When the printed board is mounted in the housing of the device, care is taken to locate the resonator fingers in relation to the frame and the metallic cover parts so that the metallic frame parts and the metal covers to be fastened to the frame will surround the fingers at a suitable distance and essentially on all sides. The resonator rods can be cut to form a filter of the comb type, or an interdigital filter. The printed board resonator is particularly well suited for a duplex filter.

The invention will now be described by way of example only, with reference to the accompanying drawings, of which:
Figure 1 shows a printed circuit board incorporating a filter in a first embodiment of the invention,
Figure 2 shows a plan view of the printed circuit board of Figure 1 mounted in a compartment of radiotelephone housing,
Figure 3 is a cross-section along the line A-A′ of Figure 2, and
Figure 4 shows an exploded view of a printed circuit board incorporating a filter in a second embodiment of the invention.

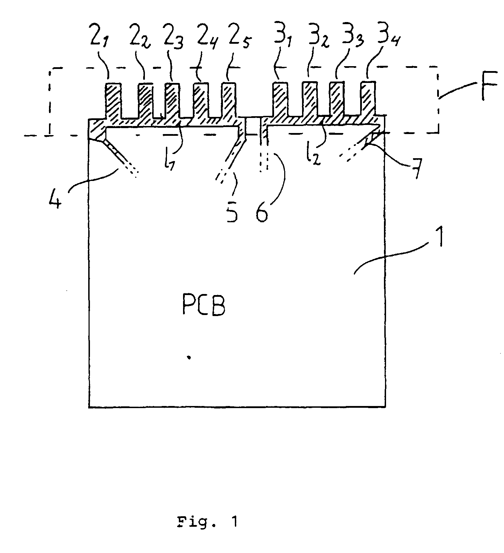

In Figure 1 the numeral 1 refers to the printed circuit board that could be of any type used in the art, for example, a single-layer board or a multilayer printed circuit board. The printed circuit board is cut to a shape determined by the components to be mounted on it, and by the available space within the radiotelephone housing. After cutting, a circuit pattern is transferred to the board 1 in a normal way by etching, and then required holes are drilled and electrical and mechanical components are mounted. The above mentioned are conventional actions which do not require detailed description.

At the same time as the printed circuit board is shaped, material is cut or milled away from its edge at selected locations to form a plurality of tongues or fingers 2₁ - 2₅ of a first filter, e.g. of the transmission side of a duplex filter, and fingers 3₁ - 3₄ of a second filter, for example to the receiver side of the duplex filter. The fingers 2₁-2₅;3₁-3₄ define the filter resonators. The fingers are entirely coated with conducting material, e.g. copper, tin, and conductor strips 1₁ and 1₂ are arranged to interconnect their bases. If, as is usual, in a printed board containing RF parts, the original printed circuit board 1 is coated with copper on both sides, then it suffices to coat only the cut edges. In the design of the circuit pattern mask, conductor strips 4, 5, 6 and 7 from the ends of the strips 1₁ and 1₂ connecting the fingers are drawn to those points on the printed board to where signals are coupled to and from the filter F₁ Thus no separate cables and connectors are required. The bases of the fingers 2₁-2₅;3₁-3₄ can be interconnected through the foil of the printed board. In this way resonators are formed directly on the printed circuit board 1, on which may be freely mounted also other components needed in the telephone.

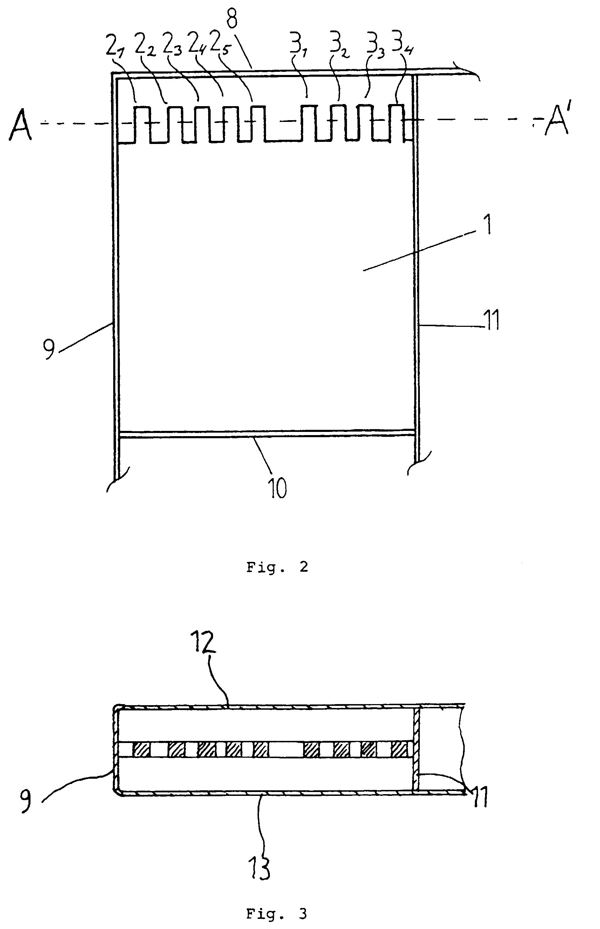

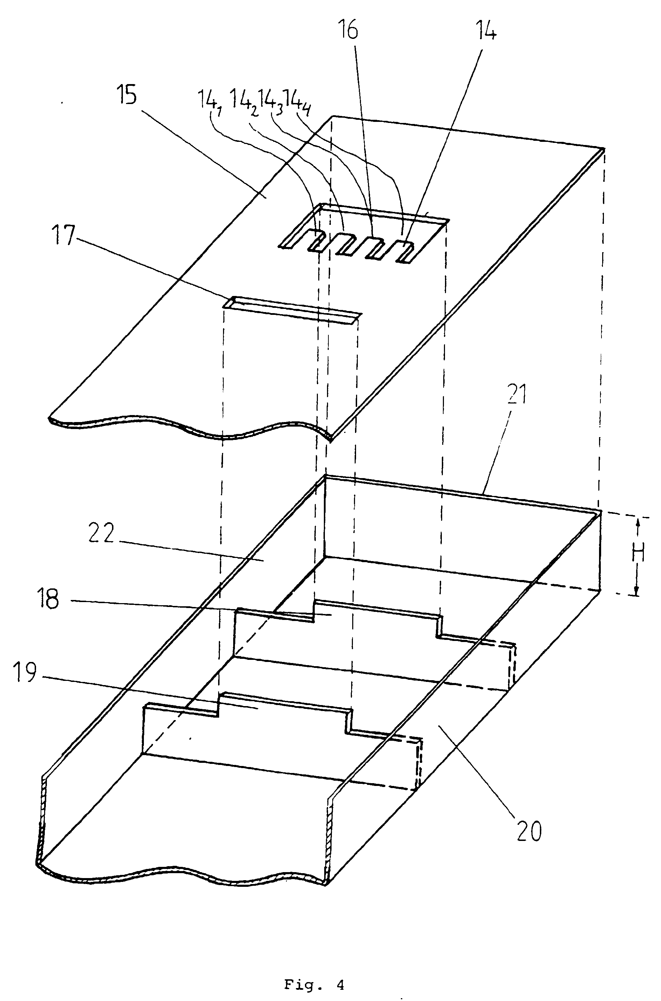

When the printed circuit board incorporating the body of resonators 2₁-2₅;3₁-3₅ is ready, required IC circuits and individual components as well as connectors are mounted on it. Then the ready and assembled printed circuit board 1 is fastened to a frame portion of a radiotelephone housing. The fastening method could be any commonly used method. In Figure 2 the circuit board is shown located in a compartment in a corner section of the frame portion, defined by outer walls 8 and 9 of the frame and walls 10 and 11 of the compartment. The printed circuit board 1 is dimensioned so that this compartment suitably can accommodate the printed circuit board 1. The printed circuit board 1 containing the filter body, i.e. the fingers 2₁ - 2₅ and 3₁ - 3₄, is placed into the frame portion so that, as shown in Figure 3, it will be centrally located in the frame, such that when covers 12 and 13 are fastened to the frame portion, the printed circuit board 1 is equidistant between the cover 12 and the cover 13, this being the most favourable situation regarding the operation of the resonators. If required, it is possible to arrange adjusting means (not shown) in cover 12,13 or in the housing wall 8, to bend either fingers away from the covers, or to adjust screws fastened to the tongues, in order to tune the resonant frequency of the resonators. To a person skilled in the art these are obvious facts, not essential regarding this invention.

Figure 4 shows a further embodiment of the invention. This differs from the first embodiment in that fingers 14₁ - 14₄, are cut in the middle of the printed circuit board 15 with an open region 16 in front of them. A slot 17 is cut behind the fingers, at right angles to the direction of the fingers 14₁-14₄. The fingers 14₁-14₄ are entirely coated with conducting material, as described above referring to Figure 1, and are connected via printed board conductor strips (not shown) directly to the electrical circuits mounted on the printed circuit board 15. A printed circuit board of this type, together with its resonators, is placed in the radiotelephone housing which has respective partitions 18,19 which are arranged, so that a portion of one partition 19 passes through the slot 17, and a portion of the other partition 18 passes through the open region 16 close to the edge opposite the fingers. The housing walls 20, 21, 22 represent the radiotelephone's outer walls and serve to enclose the printed board 15 in three directions. When the housing is made, the partitions 18 and 19 are also made. They have a height which is somewhat less than half of the housing height H, apart from the substantially centrally located extending portions which have a height equal to the housing height it whereby, in assembly, the printed circuit board 15 is placed in the housing into the space defined by walls 20, 21, 22, so that the extending portions of partitions extend through the slot 17 and through the opening 16 close to the edge away from the fingers 14₁ - 14₄. The extending portion of partition 18 is soldered adjacent the slot 17. When the printed circuit board 15 is at least partly shielded on both sides by a cover (not shown) and the base of the housing, the width of which is equal to the distance between the partitions 18 and 19, and the length of which is at least equal to the length of the partitions 18,19, the covers covering the opening 16 and the fingers 14₁-14₄, then the fingers are located at an equal distance from the cover and the base, whereby the fingers can operate as resonators and form a filter.

It will be evident from the foregoing description that various modifications may be made, by a person skilled in the art, within the scope of the present invention. For example the device could be some other radio frequency device than a radiotelephone. It is possible to cut the resonator fingers in any place on the printed board, and there are no restrictions on the form of individual fingers or on the number of filters they form. The electrical characteristics, e.g. the harmonic properties of the filter can be influenced by the form of the fingers. It is even conceivable that fingers form the body of a helix resonator, whereby the filter would be of a so called "lying helix" type. In the embodiment of Figure 4 the partial walls belong to the radiotelephone frame, but is also possible to use separate metal plates that are fastened on the printed board and that function as resonator earth planes towards the sides. It is also possible to attach, e.g. by soldering, flange-like parts to the finger ends in order to increase their capacitive coupling in a known way. Depending on the location of the filters in relation to the side walls of the frame, resonance frequency adjusting members can be placed, in accordance with prior art, in the frame side wall, in the partial walls or in the covers between which the resonators are situated.

## Claims

1. An air insulated high frequency filter for use in a radio apparatus, comprising a plurality of resonators in an electrically conductive casing, characterised in that the resonators comprise finger-like projections (2₁-2₅; 3₁-3₄; 14₁-14₄) entirely coated with electrically conductive material, and in that the plurality of finger-like projections are integrally formed in a portion of a circuit board (1;15) adapted for the mounting of electrical components.

2. An air insulated high frequency filter according to claim 1 wherein the resonators are provided at the edge of the circuit board.

3. An air insulated high frequency filter according to claim 1 wherein the resonators are provided in the centre portion of the circuit board in an opening in the printed board.

4. An air insulated high frequency filter according to claim 3, wherein the printed board comprises locating means (17) arranged to engage respective locating means on the housing to locate the centre portion in the respective compartment.

5. An air insulated high frequency filter according to claim 4, wherein the printed board locating means is a slot arranged to receive a portion of one of the compartment walls acting as the housing locating means.

6. An air insulated high frequency filter according to any preceding claim wherein the circuit board is provided with conductors (4-7) for electrically coupling the filter to components mounted on the board.

7. An air insulated high frequency filter according to any preceding claim wherein at least one compartment of a radio apparatus housing having electrically conductive compartment walls (8-11;18-22) encloses the resonators providing the electrically conductive casing.

8. An air insulated high frequency filter according to claim 7 wherein the printed board is mounted substantially centrally in said housing.

9. An air insulated high frequency filter according to claim 7 or 8 wherein the housing comprises at least one demountable cover.

10. An air insulated high frequency filter according to any of claims 7 to 9 wherein the housing is provided with means for adjusting said resonators for tuning the filter.

## Patentansprüche

1. Luftisoliertes Hochfrequenzfilter zur Verwendung in einer Funkvorrichtung, mit mehreren Resonatoren in einem elektrisch leitenden Gehäuse, **dadurch gekennzeichnet**, daß die Resonatoren fingerähnliche Vorsprünge (2₁ - 2₅; 3₁ - 3₄; 14₁ - 14₄) aufweisen, die ganz mit elektrisch leitendem Material beschichtet sind, und daß die mehreren fingerähnlichen Vorsprünge einheitlich in einem Abschnitt einer gedruckten Leiterplatte (1; 15), die für die Montage elektrischer Komponenten ausgebildet ist, hergestellt sind.

2. Luftisoliertes Hochfrequenzfilter nach Anspruch 1, **dadurch gekennzeichnet**, daß die Resonatoren an der Kante der Leiterplatte vorhanden sind.

3. Luftisoliertes Hochfrequenzfilter nach Anspruch 1, bei dem die Resonatoren im mittleren Abschnitt der Leiterplatte in einer Öffnung in der gedruckten Leiterplatte vorhanden sind.

4. Luftisoliertes Hochfrequenzfilter nach Anspruch 3, bei dem die gedruckte Leiterplatte eine Positioniereinrichtung (17) aufweist, die so angeordnet ist, daß sie mit jeweiligen Positioniereinrichtungen am Gehäuse in Eingriff steht, um den mittleren Abschnitt im jeweiligen Fach zu positionieren.

5. Luftisoliertes Hochfrequenzfilter nach Anspruch 4, bei dem die Positioniereinrichtung für die gedruckte Leiterplatte ein Schlitz ist, der so angeordnet ist, daß er einen Abschnitt einer der Fachwände aufnimmt, der als Gehäusepositioniereinrichtung wirkt.

6. Luftisoliertes Hochfrequenzfilter nach einem der vorstehenden Ansprüche, bei dem die Leiterplatte mit Leitern (4 - 7) zum elektrischen Verbinden des Filters mit auf der Platte montierten Komponenten versehen ist.

7. Luftisoliertes Hochfrequenzfilter nach einem der vorstehenden Ansprüche, bei dem mindestens ein Fach eines Funkvorrichtungsgehäuses mit elektrisch leitenden Fachwänden (8 - 11; 18 - 22), die das elektrisch leitende Gehäuse bilden, die Resonatoren umschließt.

8. Luftisoliertes Hochfrequenzfilter nach Anspruch 7, bei dem die gedruckte Platte im wesentlichen zentrisch im Gehäuse angebracht ist.

9. Luftisoliertes Hochfrequenzfilter nach Anspruch 7 oder Anspruch 8, bei dem das Gehäuse mindestens eine wegnehmbare Abdeckung aufweist.

10. Luftisoliertes Hochfrequenzfilter nach einem der Ansprüche 7 bis 9, bei dem das Gehäuse mit einer Einrichtung zum Einstellen der Resonatoren zum Abstimmen des Filters versehen ist.

## Revendications

1. Filtre à haute fréquence isolé à l'air pour emploi dans un appareil de radio, comprenant une multitude de résonateurs dans un boîtier conducteur de l'électricité, caractérisé en ce que les résonateurs comprennent des saillies analogues à des doigts (2₁-2₅; 3₁-3₄ ; 14₁-14₄) entièrement revêtues avec un matériau conducteur de l'électricité, et en ce que la multitude de saillies analogues à des doigts sont formées en une pièce dans une partie d'une plaquette à circuits (1; 15) destinée au montage de composants électriques.

2. Filtre à haute fréquence isolé à l'air selon la revendication 1, dans lequel les résonateurs sont prévus au bord de la plaquette à circuits.

3. Filtre à haute fréquence isolé à l'air selon la revendication 1, dans lequel les résonateurs sont prévus à la partie centrale de la plaquette à circuits dans une ouverture ménagée dans la plaquette imprimée.

4. Filtre à haute fréquence isolé à l'air selon la revendication 3, dans lequel la plaquette imprimée comprend un moyen de positionnement (17) disposé de manière à être en engagement avec un moyen de positionnement respectif sur le logement pour positionner la partie centrale dans le compartiment respectif.

5. Filtre à haute fréquence isolé à l'air selon la revendication 4, dans lequel le moyen de positionnement de plaquette imprimée est une fente disposée de manière à recevoir une partie de l'une des parois du compartiment agissant au moyen de positionnement du logement.

6. Filtre à haute fréquence isolé à l'air selon l'une quelconque des revendications précédentes, dans lequel la plaquette à circuits comporte des conducteurs (4-7) pour accoupler électriquement le filtre à des composants montés sur la plaquette.

7. Filtre à haute fréquence isolé à l'air selon l'une quelconque des revendications précédentes, dans lequel au moins un compartiment d'un logement d'appareil de radio comportant des parois de compartiment (8-11; 18-22) conductrices de l'électricité renferme les résonateurs fournissant le boîtier conducteur de l'électricité.

8. Filtre à haute fréquence isolé à l'air selon la revendication 7, dans lequel la plaquette imprimée est montée pratiquement au centre dudit logement.

9. Filtre à haute fréquence isolé à l'air selon la revendication 7 ou 8, dans lequel le logement comprend au moins un couvercle démontable.

10. Filtre à haute fréquence isolé à l'air selon l'une quelconque des revendications 7 à 9, dans lequel le logement comporte des moyens pour ajuster lesdits résonateurs afin d'accorder le filtre.
